# EUROPEAN PATENT APPLICATION

(11) **EP 4 651 658 A1**
(43) Date of publication of application: **19.11.2025**
(21) Application number: 25175736.5
(22) Date of filing: 12.05.2025
(51) Int. Cl.: H05K 7/20

(54) **ELECTRICAL DEVICE, ELECTRIC DRIVE SYSTEM AND VEHICLE**

(30) Priority: 16.05.2024 CN 202410612255
(71) Applicant: Valeo eAutomotive Germany GmbH, 91056 Erlangen (DE)
(72) Inventor: QU, Gongyuan, 91056 ERLANGEN (DE); ZENG, Sixiong, 91056 ERLANGEN (DE)
(74) Representative: Valeo Powertrain Systems

(57) **Abstract**

The present disclosure discloses an electrical device (10) which comprises a heat-dissipating member (100) providing a main body with a top surface (120) and a side wall (130) extending in an extension direction transverse to the top surface (120). The heat-dissipating member further comprises a cooling circuit (140) for circulating a cooling medium, and is disposed in the main body (110) and adjacent to the adjacent part (131) of the side wall (130). The electrical device (10) further comprises a power circuit board assembly (200) with a power circuit board (200a) and a heat-generating element (230) disposed on the power circuit board (200a). The electrical device (10) further comprises an insulating and heat-dissipating element (300), disposed between the adjacent part (131) of the side wall (130) and the first surface (210) of the power circuit board (200a), wherein the heat-generating element (230) is disposed on the first surface (210).

## Description

### TECHNICAL FIELD

The present disclosure relates to an electrical device, and further relates to an electric drive system comprising such an electrical device, and a vehicle comprising such an electric drive system.

### BACKGROUND

Vehicles, especially electrified vehicles strive for compactness and miniaturization of component structure. In particular, there is a desire to obtain electrical devices, such as power supply devices, that are more compact in structure and easier to assemble, with fewer components and better heat dissipation. Electrical devices such as power supply devices generally comprise a circuit board, heat-generating elements (e.g. MOSFETs, IGBTs, etc.) connected to the circuit board, and a heat sink for dissipating the heat of the heat-generating elements. In the prior art, the circuit board is generally mounted in a horizontal orientation above the heat sink. This causes several problems. Mounting the circuit board in a horizontal orientation above the heat sink often requires a plastic member for supporting and insulating the circuit board, but the presence of the plastic member prevents other components from being mounted in the vicinity of the circuit board; thus, space is wasted, making structural compactness difficult to achieve. In addition, multiple screws need to be used to fix the circuit board in place; this makes assembly more complicated, and the stress of screw products might have an adverse effect on the circuit board. Furthermore, in this case, the design of coolant channels of the heat sink need to be more complicated in order to increase the heat dissipation efficiency; for example, turbulators (e.g., ribs) and the like need to be provided in the coolant channels, but the design of such turbulators will cause an unwanted pressure drop in the coolant.

Thus, there is still a need for an improved electrical device, to achieve structural compactness and miniaturization, convenience of assembly, and guaranteed cooling efficiency without causing a pressure drop in coolant.

### SUMMARY OF THE DISCLOSURE

To this end, according to one aspect of the present disclosure, an electrical device is proposed, which is capable of solving at least one of the technical problems in the prior art, with other benefits.

According to an embodiment, the electrical device may comprise:
a heat-dissipating member, comprising:
   a main body, the main body comprising a top surface and a side wall extending in an extension direction transverse to the top surface, the side wall comprising an adjacent part;
   a cooling circuit for circulating a cooling medium, the cooling circuit being disposed in the main body and adjacent to the adjacent part of the side wall;
a power circuit board assembly, comprising a power circuit board and a heat-generating element disposed on the power circuit board, the power circuit board comprising a first surface and a second surface facing away from each other; and
an insulating and heat-dissipating element, disposed between the adjacent part of the side wall and the first surface of the power circuit board;
wherein the heat-generating element is disposed on the first surface of the power circuit board.

Thus, according to this embodiment, the cooling circuit of the heat-dissipating member is disposed adjacent to the adjacent part of the side wall of the main body, the insulating and heat-dissipating element is disposed between the adjacent part of the side wall of the main body of the heat-dissipating member and the first surface of the power circuit board, while the heat-generating element is disposed on the first surface of the power circuit board; this allows the heat of the heat-generating element to be promptly and effectively conducted to the cooling circuit (which is disposed adjacent to the adjacent part) of the heat-dissipating member via the insulating and heat-dissipating element, while ensuring electrical insulation between the side wall of the heat-dissipating member and the heat-generating element or even the power circuit board. In addition, such a structure allows the plastic member in the prior art to be omitted, and therefore overcomes the problem of space being wasted due to the presence of the plastic member, while also reducing the number of components and thus simplifying assembly, improving cost-effectiveness. In addition, such a structure also allows the structural design of the cooling circuit to be simplified, making it possible to ensure prompt and effective heat dissipation from the heat-generating element without providing any turbulator structures in the cooling circuit, and this consequently prevents a pressure drop from occurring in the cooling medium in the cooling circuit.

According to various embodiments, the electrical device proposed in the present disclosure may further comprise one or more of the following further developments, which may be used individually, or simultaneously in any technically feasible combination.

In some embodiments, the heat-generating element has a heat-dissipating surface, the heat-dissipating surface being arranged so as to face away from the power circuit board. Such a structure allows prompt and effective dissipation of heat generated by the heat-generating element to be further boosted.

In some embodiments, the heat-generating element is a surface-mount component or a through-hole component.

In some embodiments, the heat-generating element is an integrated power module and/or a discrete power device.

In some embodiments, the insulating and heat-dissipating element is a ceramic plate or a thermally conductive stick-on piece. This helps to achieve structural compactness and convenience of assembly.

In some embodiments, the electrical device further comprises a main circuit board, the main circuit board being disposed above the top surface of the main body of the heat-dissipating member and connected to the power circuit board. The main circuit board is for example mainly used for electrical and signal connections to external members. This is of further help in achieving a compact overall structure. In addition, this also optionally allows the heat-generating element to be fitted to the power circuit board in advance to form a one-piece sub-assembly, then this one-piece sub-assembly to be fitted to the heat-dissipating member, then the main circuit board to be fitted to the one-piece sub-assembly; this simplifies assembly while ensuring that the one-piece sub-assembly is held firmly and positioned precisely, thus improving cost-effectiveness.

In some embodiments, an electronic and/or an electrical element is provided on the second surface of the power circuit board. This allows full utilization of limited space, further helping to achieve structural compactness and miniaturization.

In some embodiments, the electrical device further comprises an elastic retainer for holding the power circuit board relative to the main body of the heat-dissipating member.

In some embodiments, the elastic retainer is disposed at the side of the power circuit board that faces away from the adjacent part, and comprises a fixing part and an elastic protruding piece extending from the fixing part, the fixing part being configured to be fixed relative to the main body of the heat-dissipating member, and the elastic protruding piece being configured to press the power circuit board against the adjacent part. The elastic retainer allows the fitting of the power circuit board to be simplified, and will not cause excessive local stress therein, thus avoiding potential damage associated with local stress.

In some embodiments, the fixing part of the elastic retainer is fixed to the main body of the heat-dissipating member by a threaded connection.

In some embodiments, at least one positioning post is provided on the main body of the heat-dissipating member; the fixing part of the elastic retainer is elastically deformable and provided with at least one pair of eccentric positioning holes, wherein one pair of eccentric positioning holes is fitted round the corresponding positioning post, so that the fixing part is held in place. This allows the elastic retainer to be fixed in place without the aid of a special tool, thus simplifying assembly.

In some embodiments, the electrical device is further provided with an accommodating cavity for at least partially accommodating the insulating and heat-dissipating element, the power circuit board assembly and the elastic retainer, the accommodating cavity being at least partially filled with a potting compound. The accommodating cavity and the potting compound provided therein permit electrical insulation of the power circuit board assembly and allow the power circuit board to be firmly installed in place by means of the elastic retainer.

In some embodiments, the insulating and heat-dissipating element is dimensioned to cover at least part of the heat-dissipating surface of the heat-generating element.

In some embodiments, the insulating and heat-dissipating element is dimensioned to cover at least an outer contour of the heat-generating element. This ensures effective dissipation of heat generated by the heat-generating element, while ensuring electrical insulation between the heat-generating element and the heat-dissipating member.

In some embodiments, the accommodating cavity is disposed in the main body of the heat-dissipating member. This allows further structural simplification, reducing the number of components, and therefore simplifying assembly steps and helping to achieve structural compactness.

In some embodiments, the adjacent part of the side wall defines an inner side face of the accommodating cavity. This allows effective heat dissipation to be boosted, simplifies the structure, and helps to achieve structural compactness.

In some embodiments, the electrical device comprises a housing, and the heat-dissipating member is provided integrally with the housing, or separately from the housing.

According to another aspect of the present disclosure, an electric drive system is proposed, comprising an electrical device as described in any one of the embodiments above, and thus including the effects associated with the electrical device.

According to another aspect of the present disclosure, a vehicle is proposed, comprising an electrical device as described in any one of the embodiments above, or comprising the abovementioned electric drive system, and thus including the associated effects.

### BRIEF DESCRIPTION OF THE DRAWINGS

In order to explain the technical solution of embodiments of the present disclosure more clearly, the drawings that need to be used in the embodiments will be briefly described below. It should be understood that the drawings below show only some embodiments of the present disclosure, so they should not be regarded as limiting the scope. For those of ordinary skill in the art, other related drawings could be obtained according to these drawings without inventive effort. In the drawings:
Fig. 1 is a 3D schematic drawing of an electrical device according to a first exemplary embodiment.
Fig. 2 is a 3D exploded drawing of the electrical device shown in Fig. 1.
Fig. 3 is a 3D schematic drawing of the electrical device shown in Fig. 1, with a main circuit board removed.
Fig. 4 is a 3D exploded drawing of the electrical device shown in Fig. 3.
Fig. 5 is a partial 3D drawing which schematically shows a power circuit board and a main circuit board connected together.
Fig. 6 is a 3D schematic drawing of an elastic retainer according to a first exemplary embodiment.
Fig. 7 is a sectional drawing of an electrical device according to the first exemplary embodiment.
Fig. 8 is a 3D schematic drawing of an electrical device according to a second exemplary embodiment.
Fig. 9 is a 3D exploded drawing of the electrical device shown in Fig. 8.
Fig. 10 is a 3D schematic drawing of the electrical device shown in Fig. 8, with a main circuit board removed.
Fig. 11 is a 3D exploded drawing of the electrical device shown in Fig. 10.
Fig. 12 is a 3D schematic drawing of an elastic retainer according to the second exemplary embodiment.

### DETAILED DESCRIPTION

An electrical device, an electric drive system and a vehicle according to embodiments of the present disclosure are described in detail below with reference to the drawings. To clarify the objective, technical solution and advantages of this practical disclosure, the technical solutions in embodiments of the present disclosure are described clearly and completely below in conjunction with the drawings in embodiments of the present disclosure; obviously, the embodiments described are some, not all, of the embodiments of the present disclosure.

Thus, the detailed description below of embodiments of the present disclosure provided in conjunction with the drawings is not intended to limit the claimed scope of the present disclosure, and merely shows selected embodiments of the present disclosure. All other embodiments obtained by those skilled in the art on the basis of the embodiments in the present disclosure without inventive effort are included in the scope of protection of the present disclosure.

Unless otherwise defined in the context, the singular includes the plural. Throughout this specification, the terms "comprising", "having", etc. are used herein to specify the existence of the mentioned characteristic, number, step, operation, element, component or combination thereof, without ruling out the existence or addition of one or more other characteristics, numbers, steps, operations, elements, components or combinations thereof.

In addition, although terms including ordinal numbers such as "first", "second", etc. may be used to describe various components, these components are not limited by these terms, which are merely used to differentiate one element from another. For example, without departing from the scope of the present disclosure, a first component may be referred to as a second component and, similarly, a second component may be referred to as a first component.

In the description of the present disclosure, it must be understood that orientational or positional relationships indicated by the terms "upper", "lower", "left," "right," "inner," "outer," etc. are based on the orientational or positional relationships shown in the drawings, or are the orientational or positional relationships in which the disclosed product is usually placed when used, or are the orientational or positional relationships commonly understood by those skilled in the art, and are merely intended to facilitate and simplify description of the present disclosure, rather than indicating or implying that the device or element in question must have a specific orientation or be constructed and operated in a specific orientation, and thus should not be construed as limiting the present disclosure.

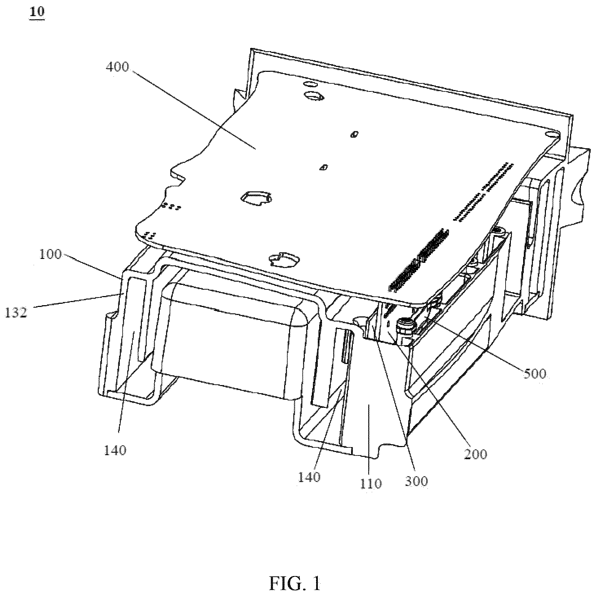

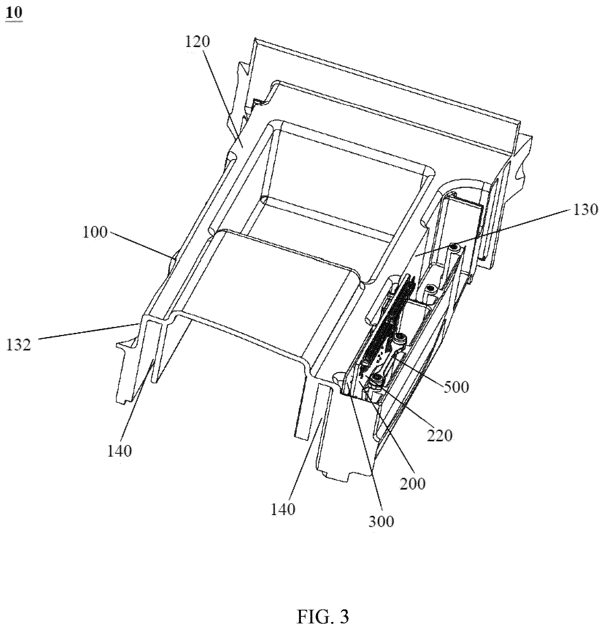

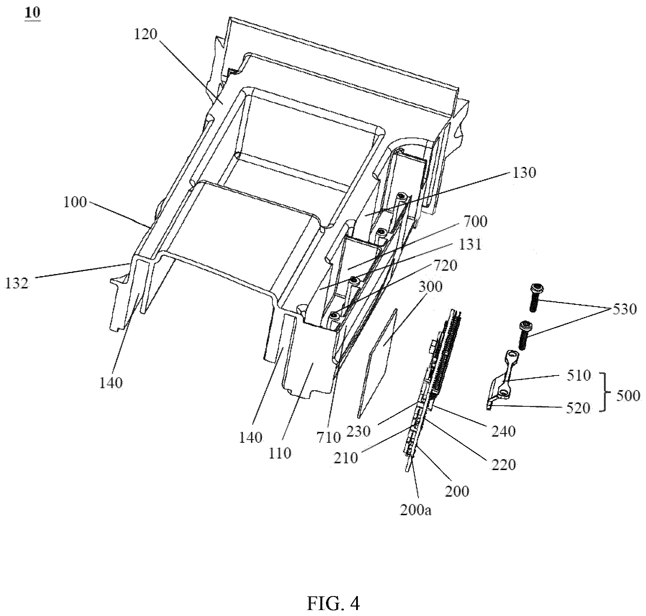

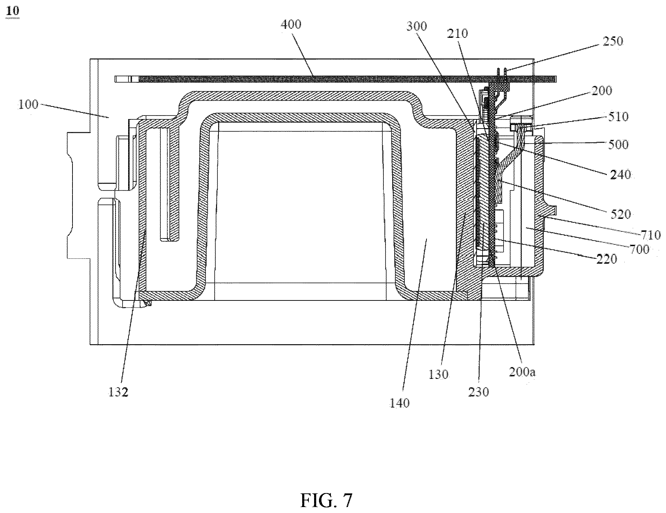

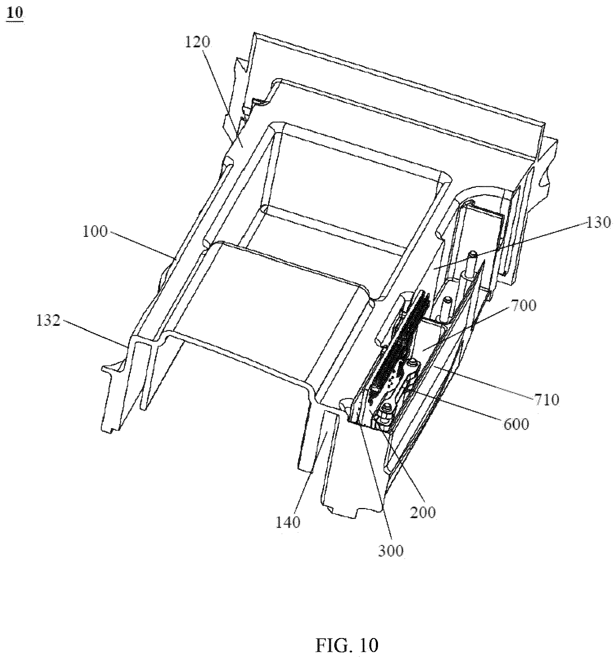

As shown in Figs. 1 - 5 and 7 - 11, an electrical device 10 is proposed in accordance with one aspect of the present disclosure. In an exemplary application environment, the electrical device 10 is part of an electric drive system or a power supply module, e.g. part of an electric drive system or an on-board power supply module of an electric vehicle or a hybrid vehicle.

As shown in Figs. 1 - 5 and 7 - 11, according to an embodiment, the electrical device 10 may comprise a power circuit board assembly 200, and the power circuit board assembly 200 may comprise a power circuit board 200a and heat-generating elements 230 disposed on the power circuit board 200a. The power circuit board 200a comprises a first surface 210 and a second surface 220 which face away from each other. In a specific embodiment, the heat-generating elements 230 may include an IGBT power transistor and/or a MOSFET. The heat-generating elements 230 will generate heat during operation, and the accumulation of this heat will cause a drop in the performance of the electrical device 10, or even damage components of the electrical device 10 or cause a safety risk. For this reason, the electrical device 10 further comprises a heat-dissipating member 100, the heat-dissipating member 100 being configured to at least dissipate the heat generated by the heat-generating elements 230.

According to some embodiments, as shown in the figures, the heat-dissipating member 100 may comprise a main body 110 and a cooling circuit 140 disposed in the main body 110, wherein a cooling medium circulates in the cooling circuit 140. The cooling medium is water in a specific embodiment, but is not limited to water. More specifically, the main body 110 of the heat-dissipating member 100 may comprise a top surface 120 and a side wall 130 extending in an extension direction transverse to the top surface 120. As used herein, the expression "transverse to" means "not parallel to", and includes "perpendicular to". The side wall 130 may comprise a part called an adjacent part 131, and the cooling circuit 140 may be disposed in the main body 110 and adjacent to the adjacent part 131. In a more specific embodiment, the heat-dissipating member 100 may comprise multiple side walls extending in an extension direction transverse to the top surface 120, e.g. a first side wall 130 and a second side wall 132 opposite each other, or optionally a third side wall (not shown in the figures) configured to connect the first side wall 130 and the second side wall 132, so that the cooling circuit is U-shaped overall. In some embodiments, the electrical device 10 may further comprise a housing, wherein the heat-dissipating member 100 may be provided integrally with the housing, or separately from the housing.

According to some embodiments, as shown in Figs. 1 - 5 and 7 - 11, the electrical device 10 further comprises an insulating and heat-dissipating element 300, disposed between the adjacent part 131 of the side wall 130 of the main body 110 of the heat-dissipating member 100 and the first surface 210 of the power circuit board 200a. More specifically, the heat-generating elements 230 are disposed on the first surface 210 of the power circuit board 200a. More specifically, the insulating and heat-dissipating element 300 is sandwiched between the adjacent part 131 of the side wall 130 of the main body 110 of the heat-dissipating member 100 and the power circuit board 200a; for example, the insulating and heat-dissipating element 300 is disposed in tight abutment with the adjacent part 131. More specifically, the heat-generating elements 230 are sandwiched between the insulating and heat-dissipating element 300 and the first surface 210 of the power circuit board 200a, and for example are disposed in tight abutment with the insulating and heat-dissipating element 300.

Thus, the electrical device 10 according to this embodiment allows the heat of the heat-generating elements 230 to be promptly and effectively conducted to the cooling circuit 140 (which is disposed adjacent to the adjacent part 131) of the heat-dissipating member 100 via the insulating and heat-dissipating element 300, while ensuring electrical insulation between the side wall 130 of the heat-dissipating member 100 and the heat-generating elements 230 or even the power circuit board 200a. In addition, such a structure allows space in the vicinity of the side wall 130 of the heat-dissipating member 100 to be fully utilized. Further, the plastic member used for mounting the circuit board in the prior art can be omitted, so the problem of space being wasted due to the presence of the plastic member is overcome; at the same time, the number of components is reduced, and assembly is simplified as a result, thus improving cost-effectiveness. In addition, such a structure also allows the structural design of the cooling circuit 140 to be simplified, making it possible to ensure prompt and effective heat dissipation from the heat-generating elements 230 without providing any turbulator structures in the cooling circuit, and this consequently prevents a pressure drop from occurring in the cooling medium in the cooling circuit 140.

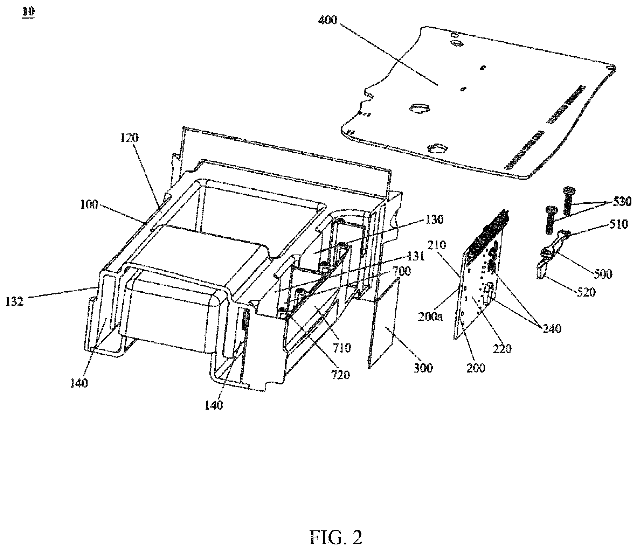

In some embodiments, the power circuit board 200a may be an aluminium substrate with a single working side, i.e. the first surface 210 with the heat-generating elements 230 mounted thereon is the working side. Alternatively, the power circuit board 200a may be a circuit board with two working sides, i.e. the first surface 210 and the second surface 220 thereof are both working sides. More specifically, as shown in Figs. 2, 4, 7 and 9, electronic and/or electrical elements 240 are provided on the second surface 220 of the power circuit board 200a. More specifically, the electronic and/or electrical elements 240 are elements that generate a relatively small amount of heat during operation, for example much less than the heat emitted by the heat-generating elements 230, and are thus able to meet heat dissipation requirements without the need for a special heat-dissipating means. The use of a circuit board with two working sides allows full utilization of limited space, further helping to achieve structural compactness and miniaturization.

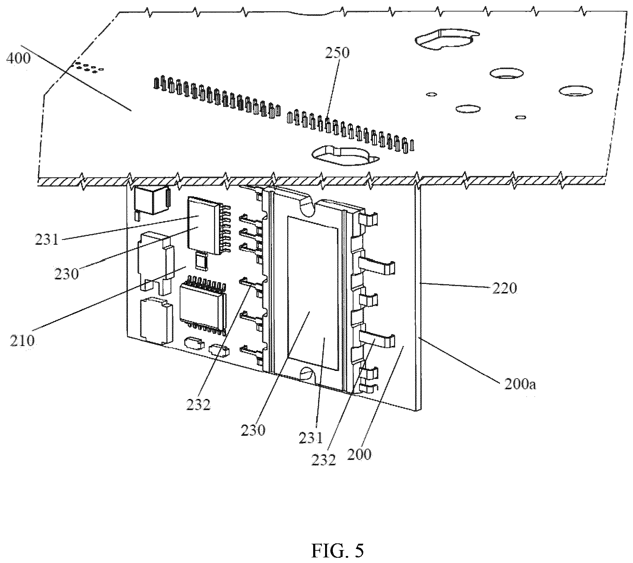

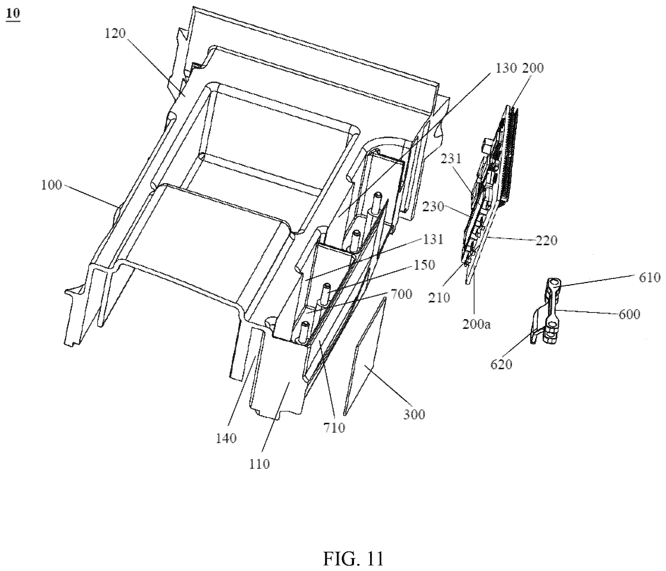

In some embodiments, as shown schematically in Figs. 5 and 11, the heat-generating elements 230 themselves may have heat-dissipating surfaces 231, and the heat generated by the heat-generating elements 230 can be dissipated away from the heat-generating elements 230 via the heat-dissipating surfaces 231 thereof. More specifically, the heat-dissipating surfaces 231 are arranged so as to face away from the power circuit board 200a. For example, the heat-generating elements 230 are arranged with their heat-dissipating surfaces 231 in tight abutment with the insulating and heat-dissipating element 300. Such a structure allows prompt and effective dissipation of heat generated by the heat-generating elements 230 to be further boosted.

In some embodiments, the heat-generating elements 230 are surface-mount components; alternatively, the heat-generating elements may be through-hole components. More specifically, the heat-generating elements 230 are surface-mounted on the power circuit board 200a. In some embodiments, the heat-generating elements 230 may be integrated power modules; alternatively, the heat-generating elements 230 may be discrete power devices.

In some embodiments, the insulating and heat-dissipating element 300 is a ceramic plate. The ceramic plate has excellent heat-conducting properties. In addition, the use of the ceramic plate helps to achieve structural compactness and convenience of assembly. Alternatively, the insulating and heat-dissipating element 300 may be a thermally conductive stick-on piece. The thermally conductive stick-on piece is for example a double- or single-sided thermally conductive stick-on piece, which may be formed of a composite material, such as silicone filled with some alumina or boron nitride. The thermally conductive stick-on piece could also be formed of thermally conductive adhesive.

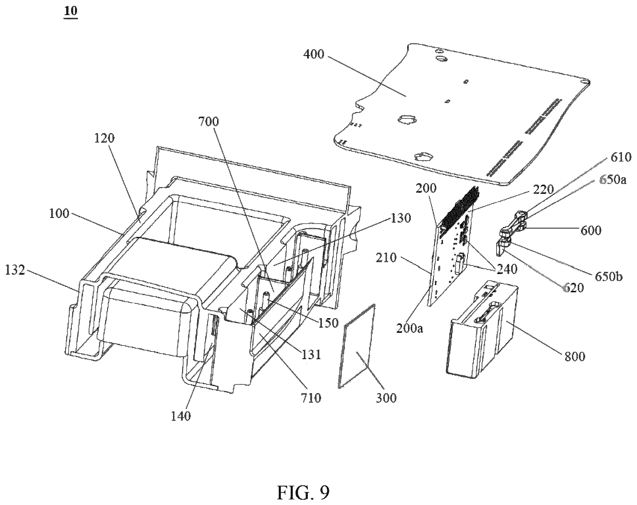

In some embodiments, as shown in Figs. 9 - 11, the electrical device 10 may also be provided with an accommodating cavity 700 for at least partially accommodating the insulating and heat-dissipating element 300 and the power circuit board assembly 200. In an embodiment, the accommodating cavity 700 is integrally provided as part of the main body 110 of the heat-dissipating member 100; this helps to achieve structural compactness, reduces the number of components, and simplifies assembly of the electrical device 10. Alternatively, the accommodating cavity 700 may be formed separately from the main body 110 of the heat-dissipating member 100, i.e. at least part (e.g. a wall) of the accommodating cavity 700 may be formed as part of the housing. In some embodiments, as shown in the figures, the adjacent part 131 of the side wall 130 of the main body 110 of the heat-dissipating member 100 defines an inner side face of the accommodating cavity 700. This allows effective heat dissipation to be further boosted, simplifies the structure, and helps to achieve structural compactness.

In some embodiments, as shown in Figs. 1 - 2, 5 and 7 - 9, the electrical device 10 may further comprise a main circuit board 400, which for example is mainly used for electrical and signal connections to external members. In such an embodiment, the main circuit board 400 may be disposed above the top surface 120 of the main body 110 of the heat-dissipating member 100 and be connected to the power circuit board 200a, e.g. connected to the power circuit board 200a via pins 250 (Figs. 5 and 7 - 8). This is of further help in achieving a compact overall structure. In addition, this also optionally allows the heat-generating elements 230 to be fitted to the power circuit board 200a in advance to form a one-piece sub-assembly, then this one-piece sub-assembly to be fitted to the heat-dissipating member 100, then the main circuit board 400 to be fitted to the one-piece sub-assembly; this simplifies assembly while ensuring that the one-piece sub-assembly is held firmly and positioned precisely, thus improving cost-effectiveness.

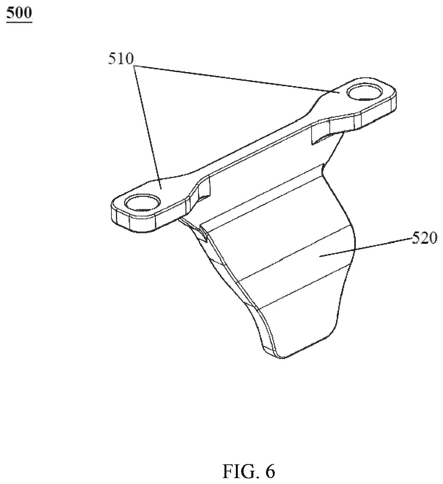

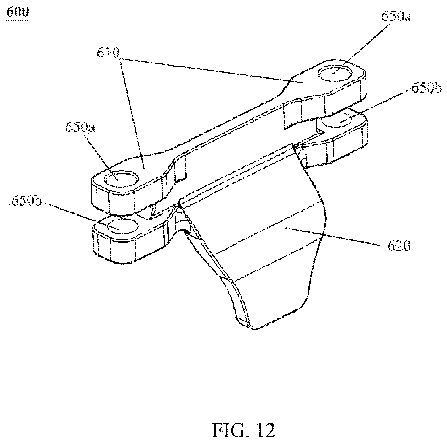

In some embodiments, as shown in Figs. 2 - 4 and 6 - 12, the electrical device 10 may further comprise an elastic retainer 500, 600 for holding the power circuit board 200a relative to the main body 110 of the heat-dissipating member 100. More specifically, the elastic retainer 500, 600 is configured to be able to apply an elastic biasing force to the power circuit board 200a, so as to press the power circuit board 200a against the main body 110 of the heat-dissipating member 100, more specifically against the adjacent part 131 of the side wall 130 of the main body 110. The elastic retainer 500, 600 allows the fitting of the power circuit board 200a to be simplified, and will not cause excessive local stress therein, thus avoiding potential damage associated with local stress. In some embodiments, as shown in Figs. 2 - 4 and 6 - 12, the elastic retainer 500, 600 may be disposed at the side of the power circuit board 200a which faces away from the adjacent part 131, i.e. configured to face towards the second surface 220 of the power circuit board 200a, more specifically, configured to apply to the second surface 220 of the power circuit board 200a an elastic biasing force that biases the power circuit board 200a towards the side wall 130 of the main body 110 of the heat-dissipating member 100. As shown in the figure, the elastic retainer 500, 600 may comprise a fixing part 510, 610 and an elastic protruding piece 520, 620 extending from the fixing part 510, 610. The fixing part 510, 610 may be configured to be fixed relative to the main body 110 of the heat-dissipating member 100, more specifically, fixed to a wall of the accommodating cavity 700 formed integrally with the main body 100 of the heat-dissipating member 100. The elastic protruding piece 520, 620 may be configured to press the power circuit board 200a against the adjacent part 131 of the side wall 130 of the main body 110 of the heat-dissipating member 100, thereby holding the power circuit board 200a in place relative to the main body 110 of the heat-dissipating member 100.

According to a first embodiment, as shown in Figs. 2 - 4 and 6 - 7, the fixing part 510 of the elastic retainer 500 is fixed to the main body 110 of the heat-dissipating member 100 by a threaded connection. More specifically, the accommodating cavity 700 for at least partially accommodating the power circuit board assembly 200 and the insulating and heat-dissipating member 300 is integrally provided on the main body 110 of the heat-dissipating member 100, a threaded connection part 720 is provided on a wall 710 forming the accommodating cavity 700, and the elastic retainer 500 is fixed to the threaded connection part 720 by a screw 530. More specifically, the elastic retainer 500 is also at least partially accommodated in the accommodating cavity 700.

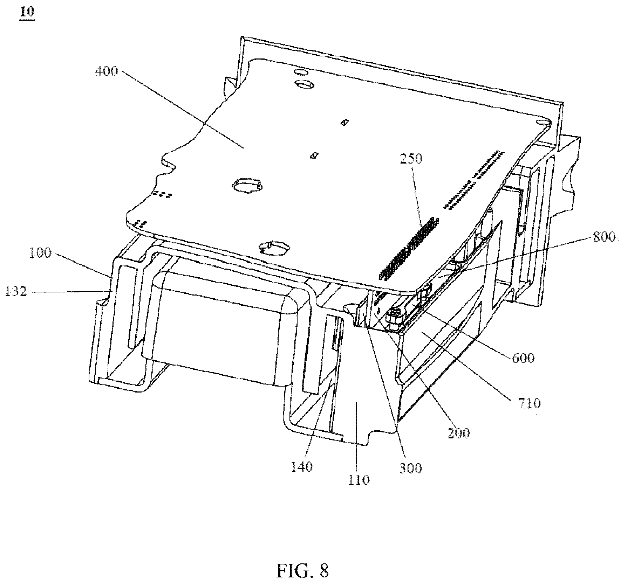

According to a second embodiment, as shown in Figs. 8 - 12, at least one positioning post 150 (two are shown in the figures) may be provided on the main body 110 of the heat-dissipating member 100, and the fixing part 610 of the elastic retainer 600 is configured to be elastically deformable and provided with at least one pair of eccentric positioning holes 650a, 650b (two pairs are shown in the figures), i.e. the positioning holes 650a and the positioning holes 650b are arranged eccentrically with respect to each other, wherein each pair of eccentric positioning holes 650a, 650b is fitted round the corresponding positioning post 150, so that the fixing part 610 is held in place. More specifically, when the fixing part 610 of the elastic retainer 600 is fitted round the corresponding positioning post 150 by means of the pair of eccentric positioning holes 650a, 650b, the fixing part 610 will deform elastically, and the elastic deformation force thereby generated can hold the fixing part 160 in place relative to the positioning post 150. This allows the elastic retainer 600 to be fixed in place without the aid of a special tool, thus simplifying assembly. Further, the accommodating cavity 700 for at least partially accommodating the power circuit board assembly 200 and the insulating and heat-dissipating member 300 is integrally provided on the main body 110 of the heat-dissipating member 100, and the positioning post 150 is formed on the wall 710 of the accommodating cavity 700. This is of further help in achieving structural compactness. More specifically, the elastic retainer 600 is also at least partially accommodated in the accommodating cavity 700.

In some embodiments, more specifically, the accommodating cavity 700 may be at least partially filled with a potting compound 800, as shown in Fig. 9. The accommodating cavity 700 and the potting compound 800 provided therein permit electrical insulation of the power circuit board assembly 200, e.g. electrical insulation between the side wall 130 of the main body 110 of the heat-dissipating member 100 and the heat-generating elements 230 or even the power circuit board 200a, while the potting compound 800 also helps the power circuit board 200a to be firmly installed in place by means of the elastic retainer 500, 600. It should be understood that electrical insulation between the side wall of the heat-dissipating member and the heat-generating elements or even the power circuit board can also be ensured by means of the insulating and heat-dissipating element alone, without filling with potting compound.

In some embodiments, the insulating and heat-dissipating element 300 is dimensioned to cover at least part of the heat-dissipating surfaces 231 of the heat-generating elements, for example, to only cover the heat-dissipating surfaces 231 of the heat-generating elements.

In some embodiments, according to a more specific mode of implementation, the insulating and heat-dissipating element 300 may be dimensioned to cover at least an outer contour of the heat-generating elements 230. It should be noted that the outer contour mentioned here refers to a contour that encompasses any peripheral parts of the heat-generating elements 230, such as various pins 232 projecting from peripheral edges of the heat-generating elements 230 in Fig. 5. This ensures effective dissipation of heat generated by the heat-generating elements 230, while ensuring electrical insulation between the heat-generating elements 230 and the heat-dissipating member 100.

According to another aspect of the present disclosure, an electric drive system is proposed, comprising an electrical device 1 as described in any one of the embodiments above, and thus including the effects associated with the electrical device.

According to another aspect of the present disclosure, a vehicle is proposed, comprising an electrical device 10 as described in any one of the embodiments above, or comprising the abovementioned electric drive system, and thus including the associated effects. It should be noted that herein, the vehicle may be an electrified vehicle, for example, a battery electric vehicle (BEV), a hybrid electric vehicle (HEV), a plug-in hybrid electric vehicle (PHEV), a range extended EV (REEV), or a fuel cell electric vehicle (FCEV). The vehicle may also be a hydrogen-powered vehicle.

Demonstrative embodiments of the electrical device, electric drive system and vehicle proposed in the present disclosure have been described in detail above with reference to preferred embodiments. However, those skilled in the art will understand that without departing from the concept of the present disclosure, various modifications and alterations may be made to the specific embodiments above, and various technical features and structures proposed in the present disclosure may be combined in various ways, without exceeding the scope of protection of the present disclosure.

The scope of the present disclosure is not defined by the embodiments described above, but by the appended claims and their equivalent scope.

## Claims

1. An electrical device (10), comprising:
a heat-dissipating member (100), comprising:
a main body (110), the main body (110) comprising a top surface (120) and a side wall (130) extending in an extension direction transverse to the top surface (120), and the side wall (130) comprising an adjacent part (131);
a cooling circuit (140) for circulating a cooling medium, and the cooling circuit (140) being disposed in the main body (110) and adjacent to the adjacent part (131) of the side wall (130);
a power circuit board assembly (200), comprising a power circuit board (200a) and a heat-generating element (230) disposed on the power circuit board, and the power circuit board comprising a first surface (210) and a second surface (220) facing away from each other; and
an insulating and heat-dissipating element (300), disposed between the adjacent part (131) of the side wall (130) and the first surface (210) of the power circuit board (200a);
wherein the heat-generating element (230) is disposed on the first surface (210) of the power circuit board (200a).

2. The electrical device (10) according to Claim 1, wherein the heat-generating element (230) has a heat-dissipating surface (231), and the heat-dissipating surface (231) is arranged so as to face away from the power circuit board (200a).

3. The electrical device (10) according to Claim 2, wherein the heat-generating element (230) is a surface-mount component or a through-hole component, and the heat-generating element (230) is an integrated power module and/or a discrete power device.

4. The electrical device (10) according to any one of Claims 1 - 3, wherein the insulating and heat-dissipating element (300) is a ceramic plate or a thermally conductive stick-on piece.

5. The electrical device (10) according to any one of Claims 1 - 3, further comprising a main circuit board (400), and the main circuit board (400) being disposed above the top surface (120) of the main body (110) of the heat-dissipating member (100) and connected to the power circuit board (200a).

6. The electrical device (10) according to any one of Claims 1 - 3, wherein an electronic and/or an electrical element (240) is provided on the second surface (220) of the power circuit board (200a).

7. The electrical device (10) according to Claim 2, further comprising an elastic retainer (500, 600) for holding the power circuit board (200a) relative to the main body (110) of the heat-dissipating member (100).

8. The electrical device (10) according to Claim 7, wherein the elastic retainer (500, 600) is disposed at the side of the power circuit board (200a) that faces away from the adjacent part (131), and comprises a fixing part (510, 610) and an elastic protruding piece (520, 620) extending from the fixing part (510, 610), and the fixing part (510, 610) being configured to be fixed relative to the main body (110) of the heat-dissipating member (100), and the elastic protruding piece (520, 620) being configured to press the power circuit board (200a) against the adjacent part (131).

9. The electrical device (10) according to Claim 8, wherein the fixing part (510) is fixed to the main body (110) of the heat-dissipating member (100) by a threaded connection.

10. The electrical device (10) according to Claim 8, wherein
at least one positioning post (150) is provided on the main body (110) of the heat-dissipating member (100);
the fixing part (610) is elastically deformable and provided with at least one pair of eccentric positioning holes (650a, 650b), wherein one pair of eccentric positioning holes (650a, 650b) is fitted round the corresponding positioning post (150), so that the fixing part (610) is held in place.

11. The electrical device (10) according to Claim 9 or 10, further provided with an accommodating cavity (700) for at least partially accommodating the insulating and heat-dissipating element (300), the power circuit board assembly (200) and the elastic retainer (500, 600), and the accommodating cavity (700) being at least partially filled with a potting compound (800).

12. The electrical device (10) according to Claim 9 or 10, wherein the insulating and heat-dissipating element (300) is dimensioned to cover at least part of the heat-dissipating surface (231).

13. The electrical device (10) according to Claim 12, wherein the insulating and heat-dissipating element (300) is dimensioned to cover at least an outer contour of the heat-generating element (230).

14. An electric drive system, comprising the electrical device (1) according to any one of Claims 1 - 13.

15. A vehicle, comprising the electrical device according to any one of Claims 1 - 13, or comprising the electric drive system according to Claim 14.
